(19) **Europäisches Patentamt / European Patent Office / Office européen des brevets**

(11) **EP 4 435 440 A1**

(12) **EUROPEAN PATENT APPLICATION**
published in accordance with Art. 153(4) EPC

(43) Date of publication:
**25.09.2024 Bulletin 2024/39**

(21) Application number: **23736992.1**

(22) Date of filing: **03.01.2023**

(51) International Patent Classification (IPC):
**G01R 27/02** (2006.01)

(86) International application number:
**PCT/CN2023/070170**

(87) International publication number:
**WO 2023/131127 (13.07.2023 Gazette 2023/28)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **06.01.2022 CN 202210007499**

(71) Applicant: **Hoymiles Power Electronics Inc.**
**Hangzhou, Zhejiang 310015 (CN)**

(72) Inventors:
- **WENG, Bingwen**
  **Hangzhou, Zhejiang 310015 (CN)**
- **LIAO, Yafeng**
  **Hangzhou, Zhejiang 310015 (CN)**
- **ZHANG, Benben**
  **Hangzhou, Zhejiang 310015 (CN)**
- **LV, Qingfeng**
  **Hangzhou, Zhejiang 310015 (CN)**

(74) Representative: **Richards, John**
**Ladas & Parry LLP**
**Temple Chambers**
**3-7 Temple Avenue**
**London EC4Y 0DA (GB)**

(54) **DETECTION METHOD AND DEVICE FOR INSULATION IMPEDANCE OF DIRECT CURRENT SIDE OF PHOTOVOLTAIC INVERTER**

(57) The present application discloses a method and apparatus for detecting insulation impedance of a direct current side of a photovoltaic inverter. The photovoltaic inverter includes a direct current input terminal, a positive terminal of a direct current bus, a negative terminal of the direct current bus, a signal protective earthing, and a protective earthing. The direct current input terminal of the photovoltaic inverter is used to connect at least one string of photovoltaic panels. The method includes the following steps: sampling a voltage of the protective earthing and a voltage of the positive terminal of the direct current bus respectively; obtaining a first voltage difference between voltages of the protective earthing at different moments and a second voltage difference between voltages of the positive terminal of the direct current bus at different moments; and calculating the insulation impedance of the direct current side of the photovoltaic inverter based on the first voltage difference, the second voltage difference, a resistance of an equivalent resistor between each terminal of the photovoltaic inverter and the signal protective earthing, and resistances of equivalent resistors between the positive terminal and the negative terminal of the direct current bus and the protective earthing. According to the method, an impact of the resistance of the resistor between each terminal and the signal protective earthing is eliminated, so that detection accuracy is improved, and there is no need to add an additional device, costs are reduced.

Sample a voltage $U_{PE}$ of a protective earthing PE and a voltage $U_{BUS+}$ of a positive terminal BUS+ of a direct current bus respectively

Obtain a first voltage difference $\Delta U_{PE}$ between voltages $U_{PE}$ of the protective earthing PE at different moments and a second voltage difference $\Delta U_{BUS+}$ between voltages $U_{BUS+}$ of the positive terminal BUS+ of the direct current bus at different moments

Calculate insulation impedance of a direct current side of a photovoltaic inverter based on the first voltage difference $\Delta U_{PE}$, the second voltage difference $\Delta U_{BUS+}$, an resistance of an Equivalent resistor between each terminal of the photovoltaic inverter to a signal ground SGND, and resistances of equivalent resistors between the positive terminal BUS+ and a negative terminal BUS– of the direct current bus and the protective earthing PE

FIG. 1

**Description**

**CROSS-REFERENCE TO RELATED APPLICATIONS**

This application claims priority to Chinese Patent Application No. CN202210007499.3, filed on January 6, 2022 and entitled "METHOD AND APPARATUS FOR DETECTING INSULATION IMPEDANCE OF DIRECT CURRENT SIDE OF PHOTOVOLTAIC INVERTER", which is incorporated herein by reference in its entirety.

**TECHNICAL FIELD**

The present invention relates to the field of power electronic technologies, and in particular, to a method and apparatus for detecting insulation impedance of a direct current side of a photovoltaic inverter.

**BACKGROUND**

A direct current input side of a photovoltaic inverter is connected to a photovoltaic panel during operation. The photovoltaic panel is floating in normal conditions, and impedance of the photovoltaic panel to the ground is infinite. However, under special circumstances such as in rain, snow, or heavy fog, insulation impedance of the photovoltaic panel to the ground may be reduced, if the photovoltaic inverter works in this case, personal safety may be endangered.

Safety standards require that only when the impedance of the photovoltaic panel to the ground $R_{ISO} > \frac{U_{Max}}{30mA}$ (in which $U_{Max}$ is a maximum voltage of the photovoltaic panel), the photovoltaic inverter is permitted to operate. Therefore, detecting the insulation impedance is a function necessary for the photovoltaic inverter.

An alternating current injection and an electric bridge method are commonly used to detect insulation impedance currently. The alternating current injection method is to inject a low-frequency alternating current signal between a positive bus and a negative bus of a photovoltaic inverter, and determine insulation impedance by detecting a leakage current. This method is affected by distributed capacitance of the photovoltaic panel, and costs are high. The bridge method is to build a bridge with resistors, control a resistance of one bridge arm through a switch, and then calculate insulation impedance by detecting changes of a voltage. This method is less costly, but the addition of a relay is still needed to control connection and disconnection of resistors of a bridge arm.

**SUMMARY**

An objective of this application is to provide a technical solution to improve accuracy of detecting insulation impedance of a direct current side of a photovoltaic inverter and reduce detection costs.

To implement the foregoing objective, this application provides a method for detecting insulation impedance of a direct current side of a photovoltaic inverter. The photovoltaic inverter includes a direct current input terminal, a positive terminal of a direct current bus, a negative terminal of the direct current bus, a signal protective earthing, and a protective earthing. The direct current input terminal of the photovoltaic inverter is used to connect to at least one string of photovoltaic panels.

The method includes the following steps:

sampling a voltage of the protective earthing and a voltage of the positive terminal of the direct current bus respectively;
obtaining a first voltage difference between voltages of the protective earthing at different moments and a second voltage difference between voltages of the positive terminal of the direct current bus at different moments; and
calculating the insulation impedance of the direct current side of the photovoltaic inverter based on the first voltage difference, the second voltage difference, a resistance of an equivalent resistor between each terminal of the photovoltaic inverter and the signal protective earthing, and resistances of equivalent resistors between the positive terminal and the negative terminal of the direct current bus and the protective earthing.

The method further includes:

establishing an equivalent circuit of insulation impedance with an equivalent resistor between each terminal of the photovoltaic inverter and the signal protective earthing and an equivalent resistor between each terminal of the photovoltaic inverter and the protective earthing based on an actual circuit of the photovoltaic inverter, where the equivalent circuit of insulation impedance includes a first equivalent resistor between the protective earthing and the signal protective earthing, one terminal of the first equivalent resistor is connected to a first branch that comprises equivalent resistors between the positive terminal and the negative terminal of the direct current bus and the protective earthing, and the other terminal of the first equivalent resistor is connected to a second branch that comprises a equivalent resistor between each terminal of the photovoltaic inverter and the signal protective earthing;

obtaining a current balance equation of the first branch and a current balance equation of the second branch respectively based on the equivalent circuit of insulation impedance;

obtaining a relational equation between the voltage of the positive terminal of the direct current bus and the voltage of the protective earthing based on the current balance equations of the first branch and the second branch; and

performing subtraction on the relational equations between a voltage of the positive terminal of the direct current bus and a voltage of the protective earthing at different moments, to obtain the insulation impedance of the direct current side of the photovoltaic inverter.

Further, the insulation impedance of the direct current side of the photovoltaic inverter is:

$$R_{ISO} = \frac{\Delta U_{PE}}{\Delta U_{BUS+} - \frac{K_2}{K_1} * \Delta U_{PE}} * \frac{1}{K_1}.$$

$R_{ISO}$ is the insulation impedance of the direct current side of the photovoltaic inverter. $\Delta U_{PE}$ is the first voltage difference. $\Delta U_{BUS+}$ is the second voltage difference. $K_1$ and $K_2$ are coefficients for calculating the insulation impedance of the direct current side of the photovoltaic inverter, and are related to the resistance of an equivalent resistor between each terminal of the photovoltaic inverter and the signal protective earthing and the resistances of the equivalent resistors between the positive terminal and the negative terminal of the direct current bus and the protective earthing.

Further, the first branch includes a second equivalent resistor between the positive terminal of the direct current bus and the protective earthing, a third equivalent resistor between the negative terminal of the direct current bus and the protective earthing, and insulation impedance of the photovoltaic panels to the protective earthing. The insulation impedance of the photovoltaic panels to the protective earthing is the insulation impedance of the direct current side of the photovoltaic inverter.

The second branch includes a fourth equivalent resistor between a positive input terminal of the photovoltaic inverter and the signal protective earthing, a fifth equivalent resistor between the positive terminal of the direct current bus and the signal protective earthing, and a sixth equivalent resistor between the negative terminal of the direct current bus and the signal protective earthing of the photovoltaic inverter.

The coefficients $K_1$ and $K_2$ are respectively:

$$\begin{cases} K_1 = \frac{1}{R_P} + \frac{1}{R_{PE}*R_{BUS+}*\left(\frac{1}{R_{PV}}+\frac{1}{R_{BUS+}}+\frac{1}{R_{PE}}+\frac{1}{R_{BUS-}}\right)} \\ K_2 = \frac{1}{R_N} + \frac{1}{R_P} + \frac{1}{R_{PE}} - \frac{1}{R_{PE}*R_{BUS+}*\left(\frac{1}{R_{PV}}+\frac{1}{R_{BUS+}}+\frac{1}{R_{PE}}+\frac{1}{R_{BUS-}}\right)} \end{cases}.$$

$R_{PE}$ represents a resistance of the first equivalent resistor. $R_P$ represents a resistance of the second equivalent resistor. $R_N$ represents a resistance of the third equivalent resistor. $R_{PV}$ represents a resistance of the fourth equivalent resistor. $R_{BUS+}$ represents a resistance of the fifth equivalent resistor. $R_{BUS-}$ represents a resistance of the sixth equivalent resistor.

Further, the positive terminal of the direct current bus and the negative terminal of the direct current bus of the photovoltaic inverter are connected to an energy storage unit. The first branch includes a second equivalent resistor between the positive terminal of the direct current bus and the protective earthing, a third equivalent resistor between the negative terminal of the direct current bus and the protective earthing, and insulation impedance of the photovoltaic panels to the protective earthing. The insulation impedance of the photovoltaic panels to the protective earthing is the insulation impedance of the direct current side of the photovoltaic inverter.

The second branch includes a fourth equivalent resistor between a positive input terminal of the photovoltaic inverter and the signal protective earthing, a fifth equivalent resistor between the positive terminal of the direct current bus and the signal protective earthing, and a sixth equivalent resistor between the negative terminal of the direct current bus and the signal protective earthing of the photovoltaic inverter.

The second branch further includes a seventh equivalent resistor between a positive input terminal of the energy storage unit and the signal protective earthing, and the coefficients $K_1$ and $K_2$ are respectively:

$$\begin{cases} K_1 = \dfrac{1}{R_P} + \dfrac{1}{R_{PE}*R_{BUS+}*\left(\frac{1}{R_{PV}}+\frac{1}{R_{BATT}}+\frac{1}{R_{BUS+}}+\frac{1}{R_{PE}}+\frac{1}{R_{BUS-}}\right)} \\ K_2 = \dfrac{1}{R_N} + \dfrac{1}{R_P} + \dfrac{1}{R_{PE}} - \dfrac{1}{R_{PE}*R_{BUS+}*\left(\frac{1}{R_{PV}}+\frac{1}{R_{BATT}}+\frac{1}{R_{BUS+}}+\frac{1}{R_{PE}}+\frac{1}{R_{BUS-}}\right)} \end{cases}.$$

$R_{PE}$ represents a resistance of the first equivalent resistor. $R_P$ represents a resistance of the second equivalent resistor. $R_N$ represents a resistance of the third equivalent resistor. $R_{PV}$ represents a resistance of the fourth equivalent resistor. $R_{BUS+}$ represents a resistance of the fifth equivalent resistor. $R_{BUS-}$ represents a resistance of the sixth equivalent resistor. $R_{BATT}$ represents a resistance of the seventh equivalent resistor.

The method further includes:

determining, based on a voltage change rate of the voltage of the protective earthing, whether the voltage of the protective earthing of the photovoltaic inverter enters a steady state before the calculating the insulation impedance of the direct current side of the photovoltaic inverter; and
calculating the insulation impedance of the direct current side of the photovoltaic inverter when the voltage of the protective earthing enters the steady state.

Further, a step of determining, based on a voltage change rate of the voltage of the protective earthing, whether the voltage of the protective earthing of the photovoltaic inverter enters a steady state includes:

sampling the voltages of the protective earthing at different moments, and calculating voltage change rates of the voltage of the protective earthing in different time periods; and
determining the voltage of the protective earthing enters the steady state when an absolute value of a difference between voltage change rates in any two time periods is less than a preset threshold, where duration of the any two time periods is the same.

Further, the preset threshold is less than or equal to 0.5.

This application further provides an apparatus for detecting insulation impedance of a direct current side of a photovoltaic inverter. The apparatus includes:

a voltage sampling unit, configured to sample a voltage of a protective earthing and a voltage of a positive terminal of a direct current bus of the photovoltaic inverter; and
a processing unit, including a calculating unit for calculating a first voltage difference between voltages of the protective earthing at different moments and a second voltage difference between voltages of the positive terminal of the direct current bus at different moments; and
calculating the insulation impedance of the direct current side of the photovoltaic inverter based on the first voltage difference, the second voltage difference, a resistance of an equivalent resistor of each terminal of the photovoltaic inverter to a signal protective earthing, and resistances of the equivalent resistors between the positive terminal and a negative terminal of the direct current bus and the protective earthing.

The insulation impedance of the direct current side of the photovoltaic inverter is:

$$R_{ISO} = \frac{\Delta U_{PE}}{\Delta U_{BUS+}-\frac{K_2}{K_1}*\Delta U_{PE}} * \frac{1}{K_1}.$$

$R_{ISO}$ is the insulation impedance of the direct current side of the photovoltaic inverter, $\Delta U_{PE}$ is the first voltage difference, $\Delta U_{BUS+}$ is the second voltage difference, and $K_1$ and $K_2$ are coefficients for calculating the insulation impedance of the direct current side of the photovoltaic inverter, and are related to the resistance of the equivalent resistor between each terminal of the photovoltaic inverter and the signal protective earthing and the resistances of the equivalent resistors between the positive terminal and the negative terminal of the direct current bus and the protective earthing.

The processing unit further includes a determining unit. The determining unit calculates and obtains voltage change rates of the voltage of the protective earthing in different time periods and determines whether the voltage of the protective earthing enters a steady state. The calculating unit calculates the insulation impedance of the direct current side of the photovoltaic inverter when the voltage of the protective earthing enters the steady state.

The determining unit determines the voltage of the protective earthing enters the steady state when an absolute value of a difference between voltage change rates in any two time periods is less than a preset threshold, wherein duration of the any two time periods is the same.

The apparatus further includes a control unit. When the insulation impedance of the direct current side of the photovoltaic inverter calculated by the processing unit is less than a preset impedance value, the control unit prohibits the photovoltaic inverter from starting, and the detection of the insulation impedance of the direct current side of the photovoltaic inverter continues. When the insulation impedance is greater than the preset impedance value, the control unit allows the photovoltaic inverter to start.

**BRIEF DESCRIPTION OF THE DRAWINGS**

FIG. 1 is a flowchart of a method for detecting insulation impedance of a direct current side of a photovoltaic inverter according to the present application;

FIG. 2 is a schematic diagram of a structure of a photovoltaic power generating system according to the present application;

FIG. 3 is a schematic diagram of an equivalent circuit of insulation impedance of the photovoltaic power generating system shown in FIG. 2 according to the present application;

FIG. 4 is a schematic diagram of an equivalent circuit of insulation impedance with a capacitance between a direct current bus and a protective earthing according to the present application; and

FIG. 5 is a schematic diagram of an apparatus for detecting insulation impedance of a direct current side of a photovoltaic inverter according to the present application.

**DETAILED DESCRIPTION**

The present invention is described in detail in the following with reference to specific embodiments shown in the accompanying drawings. However, the present invention is not limited to the embodiments. Changes of structure, method, or function made by a person of ordinary skill in the art based on the embodiments shall fall within the protection scope of the present invention.

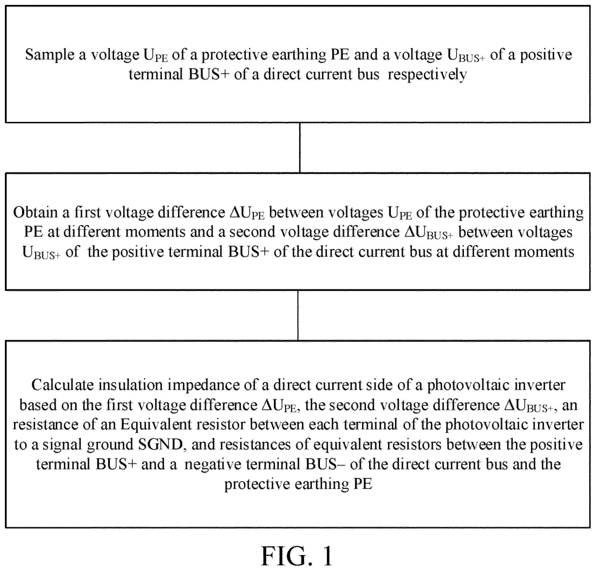

This application provides a method for detecting insulation impedance of a direct current side of a photovoltaic inverter. The photovoltaic inverter includes a direct current input terminal, a positive terminal BUS+ of a direct current bus, a negative terminal BUS- of the direct current bus, a signal protective earthing SGND, and a protective earthing PE. The direct current input terminal of the photovoltaic inverter is used to connect at least one string of photovoltaic panels. FIG. 1 is a flowchart of a method for detecting insulation impedance of a direct current side of a photovoltaic inverter according to this application. The method for detecting insulation impedance of a direct current side of a photovoltaic inverter includes the following steps:

sampling a voltage $U_{PE}$ of the protective earthing PE and a voltage $U_{BUS+}$ of the positive terminal BUS+ of the direct current bus respectively, to obtain a first voltage difference $\Delta U_{PE}$ between voltages $U_{PE}$ of the protective earthing PE at different moments and a second voltage difference $\Delta U_{BUS+}$ between voltages $U_{BUS+}$ of the positive terminal BUS+ of the direct current bus at different moments; and

calculating the insulation impedance of the direct current side of the photovoltaic inverter based on the first voltage difference $\Delta U_{PE}$, the second voltage difference $\Delta U_{BUS+}$, a resistance of an equivalent resistor between each terminal of the photovoltaic inverter and the signal protective earthing SGND, and resistances of equivalent resistors between the positive terminal BUS+ and the negative terminal BUS- of the direct current bus and the protective earthing PE.

Specifically, an equivalent circuit of insulation impedance with an equivalent resistor between each terminal of the photovoltaic inverter and the signal protective earthing and an equivalent resistor between each terminal of the photovoltaic inverter and the protective earthing is established based on an actual circuit of the photovoltaic inverter. The equivalent circuit of insulation impedance includes a first equivalent resistor between the protective earthing and the signal protective earthing. One terminal of the first equivalent resistor is connected to a first branch that includes equivalent resistors between the positive terminal BUS+ and the negative terminal BUS- of the direct current bus and the protective earthing PE, and the other terminal of the first equivalent resistor is connected to a second branch that includes an equivalent resistor between each terminal of the photovoltaic inverter and the signal protective earthing.

A current balance equation of the first branch and a current balance equation of the second branch are obtained respectively based on the equivalent circuit of insulation impedance.

A relational equation between the voltage $U_{BUS+}$ of the positive terminal BUS+ of the direct current bus and the voltage $U_{PE}$ of the protective earthing PE is obtained based on the current balance equations of the first branch and the second branch.

Subtraction is performed on the relational equations between a voltage of the positive terminal of the direct current bus and a voltage of the protective earthing at different moments, to obtain the insulation impedance of the direct current side of the photovoltaic inverter.

The insulation impedance of the direct current side of the photovoltaic inverter is:

$$R_{ISO} = \frac{\Delta U_{PE}}{\Delta U_{BUS+} - \frac{K_2}{K_1} * \Delta U_{PE}} * \frac{1}{K_1}.$$

$R_{ISO}$ is the insulation impedance of the direct current side of the photovoltaic inverter. $\Delta U_{PE}$ is the first voltage difference. $\Delta U_{BUS+}$ is the second voltage difference. $K_1$ and $K_2$ are coefficients for calculating the insulation impedance of the direct current side of the photovoltaic inverter, and are related to the resistance of an equivalent resistor between each terminal of the photovoltaic inverter and the signal protective earthing and the resistances of the equivalent resistors between the positive terminal and the negative terminal of the direct current bus and the protective earthing.

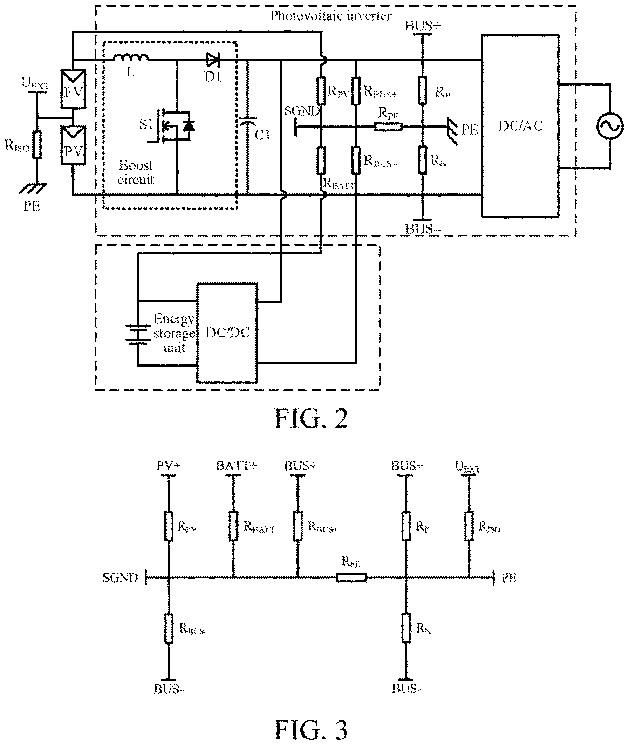

FIG. 2 is a schematic diagram of a structure of a photovoltaic power generating system. The present application uses the photovoltaic power generating system shown in FIG. 2 as an example to specifically illustrate the method for detecting insulation impedance of a direct current side of a photovoltaic inverter according to the embodiments of the present invention. The photovoltaic power generating system includes at least one photovoltaic panel, an energy storage unit, and a photovoltaic inverter. The photovoltaic inverter further includes at least one direct current conversion circuit and an inverter circuit. An output terminal of a photovoltaic panel is connected to a direct current input terminal of the photovoltaic inverter. The direct current input terminal of the photovoltaic inverter includes a positive input terminal PV+ and a negative input terminal PV-. An output voltage of the photovoltaic panel is converted into a direct current bus voltage through the direct current conversion circuit, and provided to the inverter circuit through a direct current bus. The energy storage unit includes a positive input terminal BATT+ and a negative input terminal BATT-, and is connected to the direct current bus of the photovoltaic inverter through a bidirectional DC-DC circuit.

The negative input terminal PV- of the photovoltaic inverter is connected to the negative terminal BUS- of the direct current bus and the negative input terminal BATT- of the energy storage unit. The direct current conversion circuit of the photovoltaic inverter is, for example, a Boost circuit, but is not limited thereto.

In an actual circuit of the photovoltaic power generating system, each of the above ports is connected to a protective earthing PE of the photovoltaic power generating system through a signal protective earthing SGND. Therefore, an impact of the impedance between each terminal and the signal protective earthing SGND on detection of the insulation impedance of the direct current side of the photovoltaic inverter needs to be considered.

The method includes the following steps.

The signal protective earthing SGND is used as a connection point to establish an equivalent circuit of insulation impedance, and the equivalent circuit includes equivalent resistors between each terminal of the photovoltaic inverter and the energy storage unit and the signal protective earthing SGND, and equivalent resistors between a positive terminal BUS+ and the negative terminal BUS- of the direct current bus and the protective earthing PE.

FIG. 3 is a diagram of the equivalent circuit of insulation impedance of the photovoltaic power generating system shown in FIG. 2. As shown in FIG. 3,
the signal protective earthing SGND of the photovoltaic inverter is used as a connection point. The equivalent circuit of insulation impedance includes a first equivalent resistor $R_{PE}$ between the protective earthing PE and the signal protective earthing SGND of the photovoltaic inverter. One terminal of the first equivalent resistor $R_{PE}$ is connected to a first branch, and the other terminal of the first equivalent resistor $R_{PE}$ is connected to a second branch.

The first branch includes a second equivalent resistor $R_P$ between the positive terminal BUS+ of the direct current bus of the photovoltaic inverter and the protective earthing PE, a third equivalent resistor $R_N$ between the negative terminal BUS- of the direct current bus of the photovoltaic inverter and the protective earthing PE, and insulation impedance $R_{ISO}$ of the photovoltaic panel to the protective earthing PE, the insulation impedance Riso is the insulation impedance of the direct current side of the photovoltaic inverter.

The second branch includes a fourth equivalent resistor $R_{PV}$ between the positive input terminal PV+ of the photovoltaic inverter and the signal protective earthing SGND of the photovoltaic inverter, a fifth equivalent resistor $R_{BUS+}$ between the positive terminal BUS+ of the direct current bus of the photovoltaic inverter and the signal protective earthing SGND of the photovoltaic inverter, a sixth equivalent resistor $R_{BUS-}$ between the negative terminal BUS-of the direct current bus of the photovoltaic inverter and the signal protective earthing SGND of the photovoltaic inverter, and a seventh equivalent resistor $R_{BATT}$ between the positive input terminal BATT+ of the energy storage unit and the signal protective earthing SGND of the photovoltaic inverter.

Because the energy storage unit is optional, an impact of the energy storage unit on detection of the insulation impedance of the direct current side of the photovoltaic inverter needs to be considered only when the energy storage unit accesses the photovoltaic power generating system.

A current balance equation of the first branch and a current balance equation of the second branch are obtained respectively based on the equivalent circuit of insulation impedance.

Specifically, a voltage of the negative terminal BUS- of the direct current bus is regarded as 0 V, and the current balance equation of the first branch and the current balance equation of the second branch are respectively:

$$\begin{cases} \dfrac{U_{PE}}{R_N} + \dfrac{U_{PE} - U_{SGND}}{R_{PE}} = \dfrac{U_{EXT} - U_{PE}}{R_{ISO}} + \dfrac{U_{BUS+} - U_{PE}}{R_P} \\ \dfrac{U_{PV} - U_{SGND}}{R_{PV}} + \dfrac{U_{BATT} - U_{SGND}}{R_{BATT}} + \dfrac{U_{BUS+} - U_{SGND}}{R_{BUS+}} + \dfrac{U_{PE} - U_{SGND}}{R_{RE}} = \dfrac{U_{SGND}}{R_{BUS-}} \end{cases} \quad (1).$$

$U_{PE}$ is a voltage of the protective earthing PE. $U_{SGND}$ is a voltage of the signal protective earthing SGND. $U_{EXT}$ is a voltage of an insulation impedance measurement point of the photovoltaic panel. $U_{BATT}$ is a voltage of the positive input terminal BATT+ of the energy storage unit. $U_{BUS+}$ is a voltage of the positive terminal BUS+ of the direct current bus. $U_{PV}$ is a voltage of the positive input terminal PV+. $R_P$ is an equivalent resistor between the positive terminal BUS+ of the direct current bus and the protective earthing PE. $R_N$ is an equivalent resistor between the negative terminal BUS- of the direct current bus and the protective earthing PE. $R_{PV}$ is an equivalent resistor between the positive input terminal PV+ and the SGND. $R_{BUS+}$ is an equivalent resistor between the positive terminal BUS+ of the direct current bus and the SGND. $R_{BUS-}$ is an equivalent resistor between the negative terminal BUS- of the direct current bus and the SGND. $R_{BATT}$ is an equivalent resistor between the positive input terminal BATT+ of the energy storage unit and the SGND. Riso represents the insulation impedance of the direct current side.

In the current balance equation of the first branch and the current balance equation of the second branch, resistances of the first equivalent resistor to the seventh equivalent resistor are known quantities except the insulation impedance Riso of the direct current side of the photovoltaic inverter, and may be obtained through a circuit diagram of the photovoltaic inverter.

The voltage $U_{BUS+}$ of the positive terminal BUS+ of the direct current bus of the photovoltaic inverter and the voltage $U_{PE}$ of the protective earthing PE change with the Boost circuit of the photovoltaic inverter begins to operate, while values of the voltage $U_{EXT}$ of the insulation impedance measurement point of the photovoltaic panel, the voltage $U_{PV}$, and the voltage $U_{BATT}$ remain unchanged for a specific time period. Therefore, when the voltage $U_{BUS+}$ of the positive terminal BUS+ of the direct current bus of the photovoltaic inverter and the voltage $U_{PE}$ of the protective earthing PE enter a steady state, the current balance equation of the first branch and the current balance equation of the second branch hold true.

A relational equation between the voltage $U_{BUS+}$ and the voltage $U_{PE}$ is obtained based on the current balance equations of the first branch and the second branch.

Specifically, the current balance equation of the first branch and the current balance equation of the second branch are deformed to obtain the following equation:

$$\begin{cases} U_{PE} * \left( \dfrac{1}{R_N} + \dfrac{1}{R_P} + \dfrac{1}{R_{PE}} + \dfrac{1}{R_{ISO}} \right) = \dfrac{U_{BUS+}}{R_P} + \dfrac{U_{SGND}}{R_{PE}} + \dfrac{U_{EXT}}{R_{ISO}} \\ U_{SGND} * \left( \dfrac{1}{R_{PV}} + \dfrac{1}{R_{BATT}} + \dfrac{1}{R_{BUS+}} + \dfrac{1}{R_{PE}} + \dfrac{1}{R_{BUS-}} \right) = \dfrac{U_{PV}}{R_{PV}} + \dfrac{U_{BATT}}{R_{BATT}} + \dfrac{U_{BUS+}}{R_{BUS+}} + \dfrac{U_{PE}}{R_{PE}} \end{cases} \quad (2).$$

The equations are combined to eliminate the voltage $U_{SGND}$ in Equation (2) to obtain the following relational equation:

$$U_{PE} \left( \dfrac{1}{R_N} + \dfrac{1}{R_P} + \dfrac{1}{R_{PE}} + \dfrac{1}{R_{ISO}} \right) = \dfrac{U_{BUS+}}{R_P} + \dfrac{U_{EXT}}{R_{ISO}} + \dfrac{1}{R_{PE}} * \dfrac{\frac{U_{PV}}{R_{PV}} + \frac{U_{BATT}}{R_{BATT}} + \frac{U_{BUS+}}{R_{BUS+}} + \frac{U_{PE}}{R_{PE}}}{\left( \frac{1}{R_{PV}} + \frac{1}{R_{BATT}} + \frac{1}{R_{BUS+}} + \frac{1}{R_{PE}} + \frac{1}{R_{BUS-}} \right)} \quad (3).$$

Equation (3) is deformed to obtain Equation (4):

$$U_{PE}\left(\frac{1}{R_N}+\frac{1}{R_P}+\frac{1}{R_{PE}}+\frac{1}{R_{ISO}}-\frac{1}{R_{PE}{}^2*\left(\frac{1}{R_{PV}}+\frac{1}{R_{BATT}}+\frac{1}{R_{BUS+}}+\frac{1}{R_{PE}}+\frac{1}{R_{BUS-}}\right)}\right)=\frac{U_{BUS+}}{R_P}+\frac{U_{EXT}}{R_{ISO}}+$$

$$\frac{1}{R_{PE}}*\frac{\frac{U_{PV}}{R_{PV}}+\frac{U_{BATT}}{R_{BATT}}+\frac{U_{BUS+}}{R_{BUS+}}}{\left(\frac{1}{R_{PV}}+\frac{1}{R_{BATT}}+\frac{1}{R_{BUS+}}+\frac{1}{R_{PE}}+\frac{1}{R_{BUS-}}\right)} \qquad (4).$$

Subtraction is performed on the relational equations between a value of the voltage $U_{BUS+}$ and a value of the voltage $U_{PE}$ at different moments, to obtain the insulation impedance $R_{ISO}$ of the direct current side of the photovoltaic inverter.

Specifically, when the detection of the insulation impedance is performed, and the voltage $U_{PE}$ of the protective earthing PE and the voltage $U_{BUS+}$ of the positive terminal BUS+ of the direct current bus of the photovoltaic inverter change with the operation of the Boost circuit of the photovoltaic inverter, increments of the voltage $U_{PE}$ and the voltage $U_{BUS+}$ satisfy:

$$\Delta U_{PE}\left(\frac{1}{R_N}+\frac{1}{R_P}+\frac{1}{R_{PE}}+\frac{1}{R_{ISO}}-\frac{1}{R_{PE}{}^2*\left(\frac{1}{R_{PV}}+\frac{1}{R_{BATT}}+\frac{1}{R_{BUS+}}+\frac{1}{R_{PE}}+\frac{1}{R_{BUS-}}\right)}\right)=\Delta U_{BUS+}*\left(\frac{1}{R_P}+\right.$$

$$\left.\frac{1}{R_{PE}*R_{BUS+}*\left(\frac{1}{R_{PV}}+\frac{1}{R_{BATT}}+\frac{1}{R_{BUS+}}+\frac{1}{R_{PE}}+\frac{1}{R_{BUS-}}\right)}\right) \qquad (5).$$

Equation (5) is deformed to obtain an equation of $\frac{1}{R_{ISO}}$ :

$$\frac{1}{R_{ISO}}=\frac{\Delta U_{BUS+}}{\Delta U_{PE}}*\left(\frac{1}{R_P}+\frac{1}{R_{PE}*R_{BUS+}*\left(\frac{1}{R_{PV}}+\frac{1}{R_{BATT}}+\frac{1}{R_{BUS+}}+\frac{1}{R_{PE}}+\frac{1}{R_{BUS-}}\right)}\right)-\left(\frac{1}{R_N}+\frac{1}{R_P}+\frac{1}{R_{PE}}-\right.$$

$$\left.\frac{1}{R_{PE}*R_{BUS+}*\left(\frac{1}{R_{PV}}+\frac{1}{R_{BATT}}+\frac{1}{R_{BUS+}}+\frac{1}{R_{PE}}+\frac{1}{R_{BUS-}}\right)}\right) \qquad (6).$$

$\Delta U_{BUS+}$ is a first voltage difference between the voltages $U_{BUS+}$ at different moments, and $\Delta U_{PE}$ is a second voltage difference between the voltages $U_{PE}$ at different moments.

Let:

$$\begin{cases} K_1=\dfrac{1}{R_P}+\dfrac{1}{R_{PE}*R_{BUS+}*\left(\frac{1}{R_{PV}}+\frac{1}{R_{BATT}}+\frac{1}{R_{BUS+}}+\frac{1}{R_{PE}}+\frac{1}{R_{BUS-}}\right)} \\ K_2=\dfrac{1}{R_N}+\dfrac{1}{R_P}+\dfrac{1}{R_{PE}}-\dfrac{1}{R_{PE}*R_{BUS+}*\left(\frac{1}{R_{PV}}+\frac{1}{R_{BATT}}+\frac{1}{R_{BUS+}}+\frac{1}{R_{PE}}+\frac{1}{R_{BUS-}}\right)} \end{cases} \qquad (7).$$

An equation for calculating the insulation impedance $R_{ISO}$ of the direct current side of the photovoltaic inverter is obtained as:

$$R_{ISO}=\frac{\Delta U_{PE}}{\Delta U_{BUS+}-\frac{K_2}{K_1}*\Delta U_{PE}}*\frac{1}{K_1} \qquad (8).$$

According to Equation (7) and Equation (8), in the method for detecting insulation impedance of a direct current side of a photovoltaic inverter provided in the present application, there is no need to add an additional device (for example, a relay and a resistor). The insulation impedance of the direct current side of the photovoltaic inverter can be calculated based on the first voltage difference $\Delta U_{BUS+}$, the second voltage difference $\Delta U_{PE}$ and the equivalent resistance of each terminal, the first voltage difference $\Delta U_{BUS+}$ and the second voltage difference $\Delta U_{PE}$ are calculated respectively by sampling the voltages $U_{BUS+}$ of the positive terminal BUS+ of the direct current bus of the photovoltaic inverter and the voltages $U_{PE}$ of the protective earthing PE at different moments. This method simplifies a circuit structure and reduces costs.

As another optional implementation, when no energy storage unit accesses the photovoltaic power generating system, the current balance equation of the first branch and the current balance equation of the second branch are respectively:

$$\begin{cases} \frac{U_{PE}}{R_N} + \frac{U_{PE}-U_{SGND}}{R_{PE}} = \frac{U_{EXT}-U_{PE}}{R_{ISO}} + \frac{U_{BUS+}-U_{PE}}{R_P} \\ \frac{U_{PV}-U_{SGND}}{R_{PV}} + \frac{U_{BUS+}-U_{SGND}}{R_{BUS+}} + \frac{U_{PE}-U_{SGND}}{R_{RE}} = \frac{U_{SGND}}{R_{BUS-}} \end{cases} \quad (9).$$

Equation (9) is transformed similarly to Equation (1) to Equation (6). A difference is that there is no impact of parameters of energy storage unit in Equation (9).

Finally, when no energy storage unit in the photovoltaic power generating system, the equation for calculation the insulation impedance $R_{ISO}$ of the direct current side of the photovoltaic inverter is still the Equation (8):

$$R_{ISO} = \frac{\Delta U_{PE}}{\Delta U_{BUS+} - \frac{K_2}{K_1} * \Delta U_{PE}} * \frac{1}{K_1} \quad (8).$$

However, the coefficients $K_1$ and $K_2$ in Equation (8) are respectively:

$$\begin{cases} K_1 = \frac{1}{R_P} + \frac{1}{R_{PE}*R_{BUS+}*\left(\frac{1}{R_{PV}}+\frac{1}{R_{BUS+}}+\frac{1}{R_{PE}}+\frac{1}{R_{BUS-}}\right)} \\ K_2 = \frac{1}{R_N} + \frac{1}{R_P} + \frac{1}{R_{PE}} - \frac{1}{R_{PE}*R_{BUS+}*\left(\frac{1}{R_{PV}}+\frac{1}{R_{BUS+}}+\frac{1}{R_{PE}}+\frac{1}{R_{BUS-}}\right)} \end{cases} \quad (10).$$

The method for detecting insulation impedance in this application may further be applied to a photovoltaic power generating system including a plurality of photovoltaic panels connected in series and/or in parallel, a plurality of energy storage units, and a photovoltaic inverter, but is not limited thereto.

In conclusion, in the present application, the voltages of both the protective earthing and the positive terminal of the direct current bus at different moments are sampled to respectively calculate the voltage difference of the protective earthing and the voltage difference of the positive terminal of the direct current bus, and the insulation impedance of the direct current side can be exactly calculated based on the voltage difference of the positive terminal of the direct current bus, the voltage difference of the protective earthing, a resistance of an equivalent resistor between each terminal and the signal protective earthing, and resistances of equivalent resistors between the positive terminal and the negative terminal of the direct current bus and the protective earthing. According to the method for detecting insulation impedance in the present application, an impact of the resistance of the resistor between each terminal and the signal protective earthing on detection of the insulation impedance is eliminated, and detection accuracy is high. In addition, there is no need to add an additional device (for example, a relay and a switch), so that a circuit structure is simplified and costs of the photovoltaic inverter are reduced.

Based on an actual circuit of the photovoltaic inverter, a specific quantity of Y capacitors are configured between the positive terminal BUS+ of the direct current bus of the photovoltaic inverter and the protective earthing PE as well as between the negative terminal BUS- of the direct current bus and the protective earthing. In addition, there are also parasitic capacitors in the circuit.

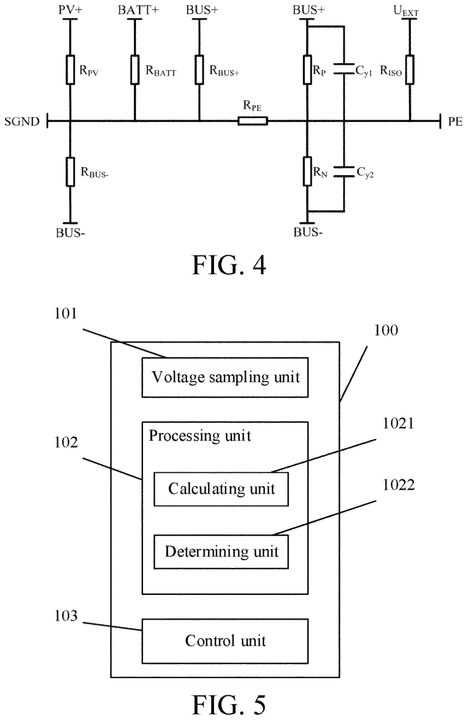

Therefore, FIG. 4 is a schematic diagram of an equivalent circuit of insulation impedance with capacitors between the direct current bus and the protective earthing PE according to the present application. Due to an impact of the Y capacitors and the parasitic capacitors, the voltage $U_{PE}$ of the protective earthing PE does not reach a steady state immediately and changes nonlinearly. If the detection of the insulation impedance of the direct current side of the photovoltaic inverter is performed before the steady state is reached, a detection value of the insulation impedance is inaccurate and has large errors compared to an actual value may be caused.

Because the Boost circuit of the photovoltaic inverter enables the voltage $U_{BUS+}$ of the positive terminal BUS+ of the direct current bus of the photovoltaic inverter to enter the steady state in a short time, an impact of the voltage $U_{BUS+}$ of the positive terminal BUS+ of the direct current bus of the photovoltaic inverter on detection of the insulation impedance of the direct current side of the photovoltaic inverter is eliminated.

To eliminate interference of the Y capacitors and the parasitic capacitors on detection of the insulation impedance of the direct current side of the photovoltaic inverter, and improve detection accuracy, as an optional implementation, the method for detecting the insulation impedance of the direct current side of the photovoltaic inverter further includes: determining whether the voltage $U_{PE}$ of the protective earthing PE of the photovoltaic inverter enters a steady state before the insulation impedance of the direct current side of the photovoltaic inverter is calculated; and then calculating the insulation impedance of the direct current side of the photovoltaic inverter when the voltage $U_{PE}$ of the protective earthing PE of the photovoltaic inverter enters the steady state.

As an optional implementation, in the present application, voltage change rates of the voltage $U_{PE}$ in different time periods are compared to determine whether the voltage $U_{PE}$ of the protective earthing PE enters the steady state, to skip a time period of transient changes in the voltage $U_{PE}$.

Specifically, the voltages $U_{PE}$ of the protective earthing PE at different moments are sampled, to calculate the voltage change rates of the voltage $U_{PE}$ in different time periods.

When an absolute value of a difference between voltage change rates of the voltage $U_{PE}$ in any two time periods is less than a preset threshold, the voltage $U_{PE}$ of the protective earthing PE enters the steady state.

As an optional implementation, it is needed to comprehensively consider detection time and detection accuracy to set the preset threshold. The preset threshold may be adjusted according to an actual demand. As an optional implementation, the preset threshold may be less than or equal to 0.5.

The following further describes, a specific process of determining, according to a comparison of voltage change rates, whether the voltage $U_{PE}$ of the protective earthing PE enters the steady state provided in this application.

Specifically, a time interval T is set, and the voltage $U_{PE}$ of the protective earthing PE is sampled every time interval T.

The voltages $U_{PE}$ of the protective earthing PE at moments of t1, t2, t3, and t4 are obtained, and are respectively denoted as $U_{PE1}$, $U_{PE2}$, $U_{PE3}$, and $U_{PE4}$.

Specifically, duration of a time period [t1-t2] and a time period [t3-t4] is the same.

Voltage change rates of the voltage $U_{PE}$ in the time periods [t1-t2] and [t3-t4] are calculated respectively.

Specifically, a voltage difference $\Delta U_{PE21}$ between the voltage $U_{PE2}$ and the voltage $U_{PE1}$ is calculated:

$$\Delta U_{PE21} = U_{PE2} - U_{PE1} \qquad (11).$$

Then, the voltage change rate $\eta_{PE}$ of the voltages $U_{PE}$ in the time period [t1-t2] is calculated:

$$\eta_{PE} = \frac{\Delta U_{PE21}}{U_{PE1}} \qquad (12).$$

A voltage difference $\Delta U_{PE43}$ between the voltage $U_{PE4}$ and the voltage $U_{PE3}$ is calculated:

$$\Delta U_{PE43} = U_{PE4} - U_{PE3} \qquad (13).$$

Then, the voltage change rate $\eta_{PE}'$ of the voltages $U_{PE}$ in the time period [t3-t4] is calculated:

$$\eta_{PE}' = \frac{\Delta U_{PE43}}{U_{PE3}} \qquad (14).$$

The voltage change rates of the voltage $U_{PE}$ in the time periods [t1-t2] and [t3-t4] are compared.

Specifically, if $\eta_{PE}$ and $\eta_{PE}'$ meet:

$$|\eta_{PE} - \eta_{PE}'| < 0.5 \qquad (15),$$

it is considered that a value of the voltage $U_{PE}$ of protective earthing PE skips the time period of transient changes and enters the steady state. In this case, the insulation impedance can be calculated without the impact of the Y capacitance and the parasitic capacitance, thereby improving detection accuracy.

In conclusion, in the present application, the voltages of both the protective earthing and the positive terminal of the direct current bus at different moments are sampled, to respectively calculate the voltage difference of the positive terminal of the direct current bus and the voltage difference of the protective earthing, and the insulation impedance of the direct current side of can be exactly calculated based on the voltage difference of the positive terminal of the direct current bus, the voltage difference of the protective earthing, a resistance of an equivalent resistor between each terminal and the signal protective earthing, and resistances of equivalent resistors of the positive terminal and the negative terminal of the direct current bus and the protective earthing. According to the method for detecting insulation impedance in this application, an impact of the resistance of the resistor between each terminal and the signal protective earthing on detection of the insulation impedance is eliminated, and detection accuracy is improved. In addition, there is no need to add an additional device (for example, a relay and a switch), so that a circuit structure is simplified and costs of the photovoltaic inverter are reduced.

Further, in this application, whether the voltage of the protective earthing enters the steady state is determined by a comparison of the voltage change rates. The time period of transient changes in the voltage is skipped without adding an additional device. This eliminates an impact of the Y capacitors and the parasitic capacitors between the positive terminal and the negative terminal of the direct current bus and the protective earthing on calculation of the insulation impedance, and further improves accuracy of detecting the insulation impedance of the direct current side of the photovoltaic inverter.

FIG. 5 is a schematic diagram of an apparatus for detecting insulation impedance of a direct current side of a photovoltaic inverter according to the present application. As an optional implementation, the apparatus 100 for detecting insulation impedance of a direct current side of a photovoltaic inverter provided in the present application includes:

a voltage sampling unit 101, configured to sample a voltage $U_{PE}$ of a protective earthing PE and a voltage $U_{BUS+}$ of a positive terminal BUS+ of a direct current bus of the photovoltaic inverter; and

a processing unit 102, where the processing unit 102 includes a calculating unit 1021 for calculating a first voltage difference $\Delta U_{PE}$ between voltages $U_{PE}$ of the protective earthing PE at different moments and a second voltage difference $\Delta U_{BUS+}$ between voltages $U_{BUS+}$ of the positive terminal BUS+ of the direct current bus at different moments, and calculating the insulation impedance of the direct current side of the photovoltaic inverter based on the first voltage difference $\Delta U_{BUS+}$, the second voltage difference $\Delta U_{PE}$, a resistance of an equivalent resistor between each terminal of the photovoltaic inverter and a signal protective earthing SGND, and resistances of equivalent resistors between the positive terminal BUS+ and a negative terminal BUS- of the direct current bus and the protective earthing PE.

As an optional implementation, the processing unit 102 further includes a determining unit 1022. The determining unit 1022 obtains voltage change rates of voltages $U_{PE}$ in different time periods and determines whether the voltage $U_{PE}$ of the protective earthing enters a steady state based on the voltage change rates. When the voltage $U_{PE}$ of the protective earthing enters the steady state, the calculating unit 1021 calculates the insulation impedance of the direct current side of the photovoltaic inverter.

When an absolute value of a difference between voltage change rates of the voltage $U_{PE}$ in any two time periods is less than a preset threshold, the determining unit 1022 determines the voltage $U_{PE}$ of the protective earthing PE enters the steady state.

The apparatus for detecting insulation impedance of a direct current side of a photovoltaic inverter provided in the present application further includes a control unit 103. When the insulation impedance of the direct current side of the photovoltaic inverter calculated by the processing unit 102 is less than a preset impedance value, the control unit 103 prohibits the photovoltaic inverter from starting, and the detection of the insulation impedance of the direct current side of the photovoltaic inverter will continue. When the insulation impedance is greater than the preset impedance value, the control unit 103 allows the photovoltaic inverter to start.

As an optional implementation, the preset impedance value of the insulation impedance of the direct current side of the photovoltaic inverter may be greater than or equal to $\dfrac{U_{Max}}{30mA}$. $U_{Max}$ is a maximum voltage of a photovoltaic panel.

In the method and apparatus for detecting insulation impedance of a direct current side of a photovoltaic inverter provided in the present application, an impact of the resistance of the resistor between each terminal of the photovoltaic inverter and the signal protective earthing as well as the capacitors arranged between the terminals of the direct current bus and the protective earthing on calculation of the insulation impedance is fully considered. Without adding an additional device, the equivalent circuit of insulation impedance detection is established, and the equations for calculating the insulation impedance are derived. The insulation impedance of the direct current side can be calculated only by detecting voltage changes of the protective earthing and the positive terminal of the direct current bus. In addition, the time period of transient changes of the voltage of the protective earthing can be skipped by comparing and determining the voltage change rates of the voltage of the protective earthing. The insulation impedance calculated using the method for detecting insulation impedance of a direct current side of a photovoltaic inverter provided in the present application is more accurate, and costs are low because no additional devices are needed.

What is disclosed above are merely preferred embodiments of the present invention, but are not used to limit the scope of the present invention. A person of ordinary skill in the art may understand that without departing from the spirit and scope of the present invention and the appended claims, alteration, modification, substitution, combination, and simplification shall be equivalent replacement forms and shall fall within the scope of the present invention.

**Claims**

1. A method for detecting insulation impedance of a direct current side of a photovoltaic inverter, wherein the photovoltaic inverter comprises a direct current input terminal, a positive terminal of a direct current bus, a negative terminal of the direct current bus, a signal protective earthing, and a protective earthing, and the direct current input terminal of the photovoltaic inverter is used to connect at least one string of photovoltaic panels; and
the method comprises the following steps:

   sampling a voltage of the protective earthing and a voltage of the positive terminal of the direct current bus respectively;
   obtaining a first voltage difference between voltages of the protective earthing at different moments and a second voltage difference between voltages of the positive terminal of the direct current bus at different moments; and
   calculating the insulation impedance of the direct current side of the photovoltaic inverter based on the first voltage difference, the second voltage difference, a resistance of an equivalent resistor between each terminal of the photovoltaic inverter and the signal protective earthing, and resistances of equivalent resistors between the positive terminal and the negative terminal of the direct current bus and the protective earthing.

2. The method for detecting insulation impedance of a direct current side of a photovoltaic inverter according to claim 1, further comprising:

   establishing an equivalent circuit of insulation impedance with an equivalent resistor between each terminal of the photovoltaic inverter and the signal protective earthing and an equivalent resistor between each terminal of the photovoltaic inverter and the protective earthing based on an actual circuit of the photovoltaic inverter, wherein the equivalent circuit of insulation impedance comprises a first equivalent resistor between the protective earthing and the signal protective earthing, one terminal of the first equivalent resistor is connected to a first branch that comprises equivalent resistors between the positive terminal and the negative terminal of the direct current bus and the protective earthing, and the other terminal of the first equivalent resistor is connected to a second branch that comprises a equivalent resistor between each terminal of the photovoltaic inverter and the signal protective earthing;
   obtaining a current balance equation of the first branch and a current balance equation of the second branch respectively based on the equivalent circuit of insulation impedance;
   obtaining a relational equation between the voltage of the positive terminal of the direct current bus and the voltage of the protective earthing based on the current balance equations of the first branch and the second branch; and
   performing subtraction on the relational equations between a voltage of the positive terminal of the direct current bus and a voltage of the protective earthing at different moments, to obtain the insulation impedance of the direct current side of the photovoltaic inverter.

3. The method for detecting insulation impedance of a direct current side of a photovoltaic inverter according to claim 1 or 2, wherein the insulation impedance of the direct current side of the photovoltaic inverter is:

$$R_{ISO} = \frac{\Delta U_{PE}}{\Delta U_{BUS+} - \frac{K_2}{K_1} * \Delta U_{PE}} * \frac{1}{K_1},$$

wherein
$R_{ISO}$ is the insulation impedance of the direct current side of the photovoltaic inverter, $\Delta U_{PE}$ is the first voltage difference, $\Delta U_{BUS+}$ is the second voltage difference, and $K_1$ and $K_2$ are coefficients for calculating the insulation impedance of the direct current side of the photovoltaic inverter, and are related to the resistance of an equivalent resistor between each terminal of the photovoltaic inverter and the signal protective earthing and the resistances of

12

the equivalent resistors between the positive terminal and the negative terminal of the direct current bus and the protective earthing.

4. The method for detecting insulation impedance of a direct current side of a photovoltaic inverter according to claim 3, wherein

the first branch comprises a second equivalent resistor between the positive terminal of the direct current bus and the protective earthing, a third equivalent resistor between the negative terminal of the direct current bus and the protective earthing, and insulation impedance of the photovoltaic panels to the protective earthing, and the insulation impedance of the photovoltaic panels to the protective earthing is the insulation impedance of the direct current side of the photovoltaic inverter;
the second branch comprises a fourth equivalent resistor between a positive input terminal of the photovoltaic inverter and the signal protective earthing, a fifth equivalent resistor between the positive terminal of the direct current bus and the signal protective earthing, and a sixth equivalent resistor between the negative terminal of the direct current bus and the signal protective earthing of the photovoltaic inverter; and
the coefficients $K_1$ and $K_2$ are respectively:

$$\begin{cases} K_1 = \dfrac{1}{R_P} + \dfrac{1}{R_{PE}*R_{BUS+}*\left(\frac{1}{R_{PV}}+\frac{1}{R_{BUS+}}+\frac{1}{R_{PE}}+\frac{1}{R_{BUS-}}\right)} \\ K_2 = \dfrac{1}{R_N} + \dfrac{1}{R_P} + \dfrac{1}{R_{PE}} - \dfrac{1}{R_{PE}*R_{BUS+}*\left(\frac{1}{R_{PV}}+\frac{1}{R_{BUS+}}+\frac{1}{R_{PE}}+\frac{1}{R_{BUS-}}\right)} \end{cases},$$

wherein
$R_{PE}$ represents a resistance of the first equivalent resistor, $R_P$ represents a resistance of the second equivalent resistor, $R_N$ represents a resistance of the third equivalent resistor, $R_{PV}$ represents a resistance of the fourth equivalent resistor, $R_{BUS+}$ represents a resistance of the fifth equivalent resistor, and $R_{BUS-}$ represents a resistance of the sixth equivalent resistor.

5. The method for detecting insulation impedance of a direct current side of a photovoltaic inverter according to claim 3, wherein the positive terminal of the direct current bus of and the negative terminal of the direct current bus of the photovoltaic inverter are connected to an energy storage unit, the first branch comprises a second equivalent resistor between the positive terminal of the direct current bus and the protective earthing, a third equivalent resistor between the negative terminal of the direct current bus and the protective earthing, and insulation impedance of the photovoltaic panels to the protective earthing, and the insulation impedance of the photovoltaic panels to the protective earthing is the insulation impedance of the direct current side of the photovoltaic inverter;

the second branch comprises a fourth equivalent resistor between a positive input terminal of the photovoltaic inverter and the signal protective earthing, a fifth equivalent resistor between the positive terminal of the direct current bus and the signal protective earthing, and a sixth equivalent resistor between the negative terminal of the direct current bus and the signal protective earthing of the photovoltaic inverter; and
the second branch further comprises a seventh equivalent resistor between a positive input terminal of the energy storage unit and the signal protective earthing, and the coefficients $K_1$ and $K_2$ are respectively:

$$\begin{cases} K_1 = \dfrac{1}{R_P} + \dfrac{1}{R_{PE}*R_{BUS+}*\left(\frac{1}{R_{PV}}+\frac{1}{R_{BATT}}+\frac{1}{R_{BUS+}}+\frac{1}{R_{PE}}+\frac{1}{R_{BUS-}}\right)} \\ K_2 = \dfrac{1}{R_N} + \dfrac{1}{R_P} + \dfrac{1}{R_{PE}} - \dfrac{1}{R_{PE}*R_{BUS+}*\left(\frac{1}{R_{PV}}+\frac{1}{R_{BATT}}+\frac{1}{R_{BUS+}}+\frac{1}{R_{PE}}+\frac{1}{R_{BUS-}}\right)} \end{cases},$$

wherein
$R_{PE}$ represents a resistance of the first equivalent resistor, $R_P$ represents a resistance of the second equivalent resistor, $R_N$ represents a resistance of the third equivalent resistor, $R_{PV}$ represents a resistance of the fourth equivalent resistor, $R_{BUS+}$ represents a resistance of the fifth equivalent resistor, $R_{BUS-}$ represents a resistance of the sixth equivalent resistor, and $R_{BATT}$ represents a resistance of the seventh equivalent resistor.

**6.** The method for detecting insulation impedance of a direct current side of a photovoltaic inverter according to claim 1, wherein the method further comprises:

determining, based on a voltage change rate of the voltage of the protective earthing, whether the voltage of the protective earthing of the photovoltaic inverter enters a steady state before calculating the insulation impedance of the direct current side of the photovoltaic inverter; and

calculating the insulation impedance of the direct current side of the photovoltaic inverter when the voltage of the protective earthing enters the steady state.

**7.** The method for detecting insulation impedance of a direct current side of a photovoltaic inverter according to claim 6, wherein a step of determining, based on a voltage change rate of the voltage of the protective earthing, whether the voltage of the protective earthing of the photovoltaic inverter enters a steady state comprises:

sampling the voltages of the protective earthing at different moments, and calculating voltage change rates of the voltage of the protective earthing in different time periods; and

determining the voltage of the protective earthing enters the steady state when an absolute value of a difference between voltage change rates in any two time periods is less than a preset threshold, wherein duration of the any two time periods is the same.

**8.** The method for detecting insulation impedance of a direct current side of a photovoltaic inverter according to claim 7, wherein the preset threshold is less than or equal to 0.5.

**9.** An apparatus for detecting insulation impedance of a direct current side of a photovoltaic inverter, wherein the apparatus comprises:

a voltage sampling unit, configured to sample a voltage of a protective earthing and a voltage of a positive terminal of a direct current bus of the photovoltaic inverter; and

a processing unit, comprising a calculating unit for calculating a first voltage difference between voltages of the protective earthing at different moments and a second voltage difference between voltages of the positive terminal of the direct current bus at different moments; and

calculating the insulation impedance of the direct current side of the photovoltaic inverter based on the first voltage difference, the second voltage difference, a resistance of an equivalent resistor of each terminal of the photovoltaic inverter to a signal protective earthing, and resistances of the equivalent resistors between the positive terminal and a negative terminal of the direct current bus and the protective earthing.

**10.** The apparatus for detecting insulation impedance of a direct current side of a photovoltaic inverter according to claim 9, wherein the insulation impedance of the direct current side of the photovoltaic inverter is:

$$R_{ISO} = \frac{\Delta U_{PE}}{\Delta U_{BUS+} - \frac{K_2}{K_1} * \Delta U_{PE}} * \frac{1}{K_1},$$

wherein

$R_{ISO}$ is the insulation impedance of the direct current side of the photovoltaic inverter, $\Delta U_{PE}$ is the first voltage difference, $\Delta U_{BUS+}$ is the second voltage difference, and $K_1$ and $K_2$ are coefficients for calculating the insulation impedance of the direct current side of the photovoltaic inverter, and are related to the resistance of the equivalent resistor between each terminal of the photovoltaic inverter and the signal protective earthing and the resistances of the equivalent resistors between the positive terminal and the negative terminal of the direct current bus and the protective earthing.

**11.** The apparatus for detecting insulation impedance of a direct current side of a photovoltaic inverter according to claim 9, wherein the processing unit further comprises a determining unit, the determining unit obtains voltage change rates of the voltage of the protective earthing in different time periods and determines whether the voltage of the protective earthing enters a steady state, and the calculating unit calculates the insulation impedance of the direct current side of the photovoltaic inverter when the voltage of the protective earthing enters the steady state.

**12.** The apparatus for detecting insulation impedance of a direct current side of a photovoltaic inverter according to claim 11, wherein

the determining unit determines the voltage of the protective earthing enters the steady state when an absolute value of a difference between voltage change rates in any two time periods is less than a preset threshold, wherein duration of the any two time periods is the same.

13. The apparatus for detecting insulation impedance of a direct current side of a photovoltaic inverter according to claim 11, wherein the apparatus further comprises:
a control unit, wherein when the insulation impedance of the direct current side of the photovoltaic inverter calculated by the processing unit is less than a preset impedance value, the control unit prohibits the photovoltaic inverter from starting, and the detection of the insulation impedance of the direct current side of the photovoltaic inverter continues, and when the insulation impedance is greater than the preset impedance value, the control unit allows the photovoltaic inverter to start.

Sample a voltage $U_{PE}$ of a protective earthing PE and a voltage $U_{BUS+}$ of a positive terminal BUS+ of a direct current bus respectively

Obtain a first voltage difference $\Delta U_{PE}$ between voltages $U_{PE}$ of the protective earthing PE at different moments and a second voltage difference $\Delta U_{BUS+}$ between voltages $U_{BUS+}$ of the positive terminal BUS+ of the direct current bus at different moments

Calculate insulation impedance of a direct current side of a photovoltaic inverter based on the first voltage difference $\Delta U_{PE}$, the second voltage difference $\Delta U_{BUS+}$, an resistance of an Equivalent resistor between each terminal of the photovoltaic inverter to a signal ground SGND, and resistances of equivalent resistors between the positive terminal BUS+ and a negative terminal BUS− of the direct current bus and the protective earthing PE

# FIG. 1

FIG. 2

FIG. 3

PV+ BATT+ BUS+ BUS+ U$_{EXT}$

$R_{PV}$ $R_{BATT}$ $R_{BUS+}$ $R_P$ $C_{y1}$ $R_{ISO}$

$R_{PE}$

SGND PE

$R_{BUS-}$ $R_N$ $C_{y2}$

BUS- BUS-

## FIG. 4

101

100

Voltage sampling unit

1021

Processing unit

102

Calculating unit

1022

Determining unit

103

Control unit

## FIG. 5

## INTERNATIONAL SEARCH REPORT

| International application No. |
|---|
| **PCT/CN2023/070170** |

**A. CLASSIFICATION OF SUBJECT MATTER**

G01R27/02(2006.01)i

According to International Patent Classification (IPC) or to both national classification and IPC

**B. FIELDS SEARCHED**

Minimum documentation searched (classification system followed by classification symbols)

IPC: G01R

Documentation searched other than minimum documentation to the extent that such documents are included in the fields searched

Electronic data base consulted during the international search (name of data base and, where practicable, search terms used)

CNABS; CNTXT; CNKI; VEN; USTXT; EPTXT; WOTXT; WPABS; IEEE: 杭州禾迈电力电子, 翁炳文, 廖亚锋, 张奔奔, 吕青峰, 光伏, 太阳能, 逆变器, 变换器, 绝缘, 阻抗, 电压, 等效电阻, photovoltaic, solar, inverter, insulat+, isolat+, impedance, voltage, equivalent resistance

**C. DOCUMENTS CONSIDERED TO BE RELEVANT**

| Category* | Citation of document, with indication, where appropriate, of the relevant passages | Relevant to claim No. |
|---|---|---|
| PX | CN 114019242 A (HANGZHOU HOYMILES POWER ELECTRONICS CO., LTD.) 08 February 2022 (2022-02-08) description, paragraphs [0020]-[0062], and figures 1-5 | 1-13 |
| A | CN 112924752 A (DELTA ELECTRONIC ENTERPRISE MANAGEMENT (SHANGHAI) CO., LTD.) 08 June 2021 (2021-06-08) description, paragraphs [0041]-[0066], and figure 1 | 1-13 |
| A | CN 111856144 A (AISWEI NEW ENERGY TECHNOLOGY (YANGZHONG) CO., LTD.) 30 October 2020 (2020-10-30) entire document | 1-13 |
| A | CN 108427038 A (ZTE QUANTUM CO., LTD.) 21 August 2018 (2018-08-21) entire document | 1-13 |
| A | CN 107305224 A (DELTA ELECTRONIC ENTERPRISE MANAGEMENT (SHANGHAI) CO., LTD.) 31 October 2017 (2017-10-31) entire document | 1-13 |

☑ Further documents are listed in the continuation of Box C.　　☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **13 March 2023** | **31 March 2023** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| Facsimile No. **(86-10)62019451** | Telephone No. |

Form PCT/ISA/210 (second sheet) (July 2022)

## INTERNATIONAL SEARCH REPORT

<table>
<tr><td colspan="2">International application No.<br>**PCT/CN2023/070170**</td></tr>
</table>

**C.    DOCUMENTS CONSIDERED TO BE RELEVANT**

| Category* | Citation of document, with indication, where appropriate, of the relevant passages | Relevant to claim No. |
|---|---|---|
| A | US 2017302082 A1 (DELTA ELECTRONICS (SHANGHAI) CO., LTD.) 19 October 2017 (2017-10-19)<br>entire document | 1-13 |

Form PCT/ISA/210 (second sheet) (July 2022)

| | | | | International application No. |
|---|---|---|---|---|
| | | | | **PCT/CN2023/070170** |

| Patent document cited in search report | | | Publication date (day/month/year) | Patent family member(s) | | | Publication date (day/month/year) |
|---|---|---|---|---|---|---|---|
| CN | 114019242 | A | 08 February 2022 | None | | | |
| CN | 112924752 | A | 08 June 2021 | None | | | |
| CN | 111856144 | A | 30 October 2020 | None | | | |
| CN | 108427038 | A | 21 August 2018 | None | | | |
| CN | 107305224 | A | 31 October 2017 | None | | | |
| US | 2017302082 | A1 | 19 October 2017 | US | 10411479 | B2 | 10 September 2019 |

**EP 4 435 440 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202210007499